# EUROPÄISCHE PATENTSCHRIFT

(11) **EP 4 189 412 B1**
(45) Veröffentlichungstag und Bekanntmachung des Hinweises auf die Patenterteilung: **16.04.2025**
(21) Anmeldenummer: 21737653.2
(22) Anmeldetag: 30.06.2021
(51) Int. Cl.: G01R 31/52, B60L 3/00, B60L 50/60

(54) **SENSOR FÜR EIN ELEKTRISCHES BORDNETZ**
SENSOR FOR AN ON-BOARD NETWORK
CAPTEUR POUR UN RÉSEAU DE BORD

(30) Priorität: 03.08.2020 DE 102020120433
(43) Veröffentlichungstag der Anmeldung: 07.06.2023
(73) Patentinhaber: Isabellenhütte Heusler GmbH & Co. KG, 35683 Dillenburg (DE); Bender GmbH & Co. KG, 35305 Grünberg (DE)
(72) Erfinder: MARIEN, Jan, 35745 Herborn (DE); SEEL, Benjamin, 35689 Dillenburg-Eibach (DE); LEPPER, Andreas, 35644 Hohenahr (DE); LEBEAU, Felix, 35745 Herborn (DE); WASSMANN, Alexander, 57072 Siegen (DE); LEHR, Mario, 35305 Grünberg (DE); WÖLFEL, Daniel, 35633 Lahnau (DE); BRÖCKMANN, Eckhard, 35396 Gießen (DE); WEISS, Carsten, 35321 Laubach (DE); GRÜN, Matthias, 35315 Homberg (Ohm) (DE)
(74) Vertreter: v. Bezold & Partner Patentanwälte - PartG mbB
(86) Internationale Anmeldenummer: PCT/EP2021/067959
(87) Internationale Veröffentlichungsnummer: WO 2022/028779

(56) Entgegenhaltungen:
- EP-A1- 2 717 063
- EP-A2- 2 887 081
- DE-A1- 19 950 008
- JP-A- 2011 250 558

## Beschreibung

Die Erfindung betrifft einen Sensor für ein elektrisches Bordnetz eines elektrisch angetriebenen Fahrzeugs, insbesondere in einem Elektroauto.

In modernen Kraftfahrzeugen und insbesondere in elektrisch angetriebenen Kraftfahrzeugen müssen im Bordnetz elektrische Ströme gemessen werden. Hierzu kann die sogenannte Vierleitertechnik eingesetzt werden, die beispielsweise aus EP 0 605 800 A1 bekannt ist. Dabei wird der zu messende elektrische Strom durch einen niederohmigen Strommesswiderstand ("Shunt") geleitet, wobei der Spannungsabfall über dem niederohmigen Strommesswiderstand gemessen wird und gemäß dem ohmschen Gesetz ein Maß für den zu messenden elektrischen Strom bildet. Dieses Messverfahren gemäß der Vierleitertechnik wird von Stromsensoren verwendet, wie sie beispielsweise aus EP 2 542 902 B1 und WO 2010/121841 A1 bekannt sind.

Darüber hinaus ist in Bordnetzen von Kraftfahrzeugen eine Isolationsüberwachung erforderlich, wie sie beispielsweise in der technischen Norm DIN EN 61557-8 beschrieben ist. Hierzu bieten verschiedene Halbleiterhersteller Chips an, die neben einer Strommessung auch eine passive Isolationsüberwachung ermöglichen. Eine aktive Isolationsüberwachung ist mit diesen bekannten Chips jedoch nicht möglich.

Bei den bekannten Bordnetzen von Kraftfahrzeugen werden deshalb zur Strommessung einerseits und zur aktiven Isolationsüberwachung andererseits verschiedene Komponenten benötigt.

Ferner ist zum Stand der Technik auch hinzuweisen auf DE 10 2014 204 870 A1, DE 10 2015 008 831 A1, EP 2 887 081 A2, JP 2011 250 558 A, EP 2 717 063 A1 und DE 10 2008 010 980 A1. DE 10 2014 204 870 A1 offenbart zwar eine Isolationsüberwachung, jedoch unterscheidet sich diese Veröffentlichung von der Erfindung unter anderem durch die Art der Isolationsüberwachung und auch durch die Art der Ankopplung an das Netz.

Schließlich offenbart DE 199 50 008 A1 einen Sensor gemäß dem Oberbegriff von Anspruch 1. Dieser bekannte Sensor ist jedoch noch nicht vollständig befriedigend.

Der Erfindung liegt deshalb die Aufgabe zugrunde, die Strommessung und die Isolationsüberwachung in einem elektrischen Bordnetz zu vereinfachen.

Diese Aufgabe wird durch einen erfindungsgemäßen Sensor gemäß dem Hauptanspruch gelöst.

Die Erfindung umfasst die allgemeine technische Lehre, die technischen Funktionen der Strommessung einerseits und der aktiven Isolationsüberwachung andererseits in einem einzigen Sensor zu integrieren, wodurch der bauliche Aufwand in dem Bordnetz verringert wird.

Der erfindungsgemäße Sensor weist deshalb zunächst in Übereinstimmung mit dem Stand der Technik eine Messeinrichtung zur Strommessung und/oder zur Spannungsmessung in dem elektrischen Bordnetz auf.

In einem bevorzugten Ausführungsbeispiel der Erfindung arbeitet diese Messeinrichtung zur Strommessung gemäß der bekannten Vierleitertechnik und weist hierzu einen niederohmigen Strommesswiderstand ("Shunt") auf, wie vorstehend zum Stand der Technik beschrieben wurde.

Die Erfindung ist jedoch hinsichtlich der Funktionsweise der Messeinrichtung zur Strommessung nicht auf das Messprinzip der Vierleitertechnik beschränkt. Es besteht vielmehr auch die Möglichkeit, dass die Messeinrichtung zur Strommessung andere Messprinzipien anwendet. Beispielsweise kann die Messeinrichtung zur Strommessung einen Hall-Sensor aufweisen, wie er beispielsweise aus EP 2 511 714 A2 bekannt ist. Darüber hinaus besteht im Rahmen der Erfindung auch die Möglichkeit, dass die Messeinrichtung zur Strommessung verschiedene Messprinzipien angewendet, um eine redundante Strommessung zu ermöglichen. Beispielsweise kann die Messeinrichtung einen niederohmigen Strommesswiderstand und zusätzlich einen Hall-Sensor aufweisen. Diese Art der redundanten Strommessung ist ebenfalls in EP 2 511 714 A2 beschrieben.

Darüber hinaus weist der erfindungsgemäße Sensor wie die eingangs beschriebenen herkömmlichen Chips eine integrierte Isolationsüberwachungseinrichtung auf, um eine elektrische Isolation des Bordnetzes an der High-Side und/oder an der Low-Side-Zeit des Bordnetzes zu überwachen.

Der erfindungsgemäße Sensor zeichnet sich nun dadurch aus, dass die integrierte Isolationsüberwachungseinrichtung aktiv arbeitet und zur Isolationsüberwachung Messimpulse in das Bordnetz einprägt. Im Gegensatz zu den eingangs beschriebenen bekannten Chips mit einer integrierten Isolationsüberwachungseinrichtung arbeitet die Isolationsüberwachungseinrichtung in dem erfindungsgemäßen Sensor also nicht oder zumindest nicht ausschließlich passiv.

Die Integration der aktiven Isolationsüberwachungseinrichtung in einen Sensor zur Strom- und Spannungsmessung bietet den Vorteil, dass der Kunde keine Hochspannung mehr auf sein Batteriemanagementsystem (BMS) führen muss, was dessen Hardware-Architektur deutlich vereinfacht, Prüfaufwände während der Produktion reduziert und Kosten spart.

Ein weiterer Vorteil der erfindungsgemäßen Integration der aktiven Isolationsüberwachungseinrichtung in einen Sensor zur Strom- und Spannungsmessung besteht darin, dass viele Komponenten eingespart werden können. So enthalten die bekannten Sensoren zur Strom- und Spannungsmessung viele Komponenten, die ein Stand-Alone-Isolationswächter auch benötigt (wie z.B. Spannungs-Messeingänge, AD-Wandler, Mikrocomputer, galvanische Trennung, Kommunikationsschnittstelle). Bei einer Integration der aktiven Isolationsüberwachungseinrichtung in den Sensor können diese Komponenten des Stromsensors von der aktiven Isolationsüberwachungseinrichtung mitgenutzt werden, so dass keine doppelte Ausführung dieser Komponenten mehr erforderlich ist.

In der vorliegenden Beschreibung wird die Verwendung des erfindungsgemäßen Sensors in einem Bordnetz eines Fahrzeugs beschrieben. Der erfindungsgemäße Sensor kann jedoch auch bei stationären Batterieanwendungen verwendet werden. Der im Rahmen der Erfindung verwendete konkrete Begriff eines Bordnetzes kann deshalb auch durch den allgemeineren Begriff eines elektrischen Netzes ersetzt werden. Zur Erleichterung des Verständnisses wird jedoch in dieser Beschreibung durchgehend der konkrete Begriff eines Bordnetzes verwendet.

Die im Rahmen der aktiven Isolationsüberwachung erforderliche Einkopplung von Messimpulsen in das Bordnetz erfordert eine Ankopplung der Isolationsüberwachungseinrichtung an das Bordnetz. Vorzugsweise erfolgt diese Ankopplung der Isolationsüberwachungseinrichtung zur Einkopplung der Messimpulse nicht an der High-Side (Pluspol der Batterie) und auch nicht an der Low-Side (Minuspol der Batterie) des Bordnetzes, sondern an dem Chassis-Ground des Fahrzeugs, wie noch detailliert beschrieben wird.

In einer Erfindungsvariante ist eine kapazitive Ankopplung der Isolationsüberwachungseinrichtung an das Bordnetz vorgesehen, wobei die Messimpulse dann AC-Messimpulse (AC: Alternating Current) sind. In einer weiterenErfindungsvariante ist eine resistive Ankopplung der Isolationsüberwachungseinrichtung an das Bordnetz vorgesehen, wobei die Messimpulse jedoch AC-Messimpulse sind.

Im Rahmen der Erfindung hat der Begriff High-Side - wie bereits vorstehend kurz angesprochen wurde - vorzugsweise die Bedeutung, dass das Bordnetz an der High-Side mit einem positiven Pol einer Batterie verbunden werden kann. Der Begriff der Low-Side hat dagegen im Rahmen der Erfindung vorzugsweise die Bedeutung, dass das Bordnetz an der Low-Side mit einem negativen Pol der Batterie verbunden werden kann. Davon zu unterscheiden ist das sogenannte Chassis-Ground, das von dem Fahrzeug und seinem Fahrgestell gebildet wird.

Die aktive Isolationsüberwachungseinrichtung ermöglicht nun die Ermittlung einer Ableitkapazität zwischen der Low-Side und/oder der High-Side des Bordnetzes einerseits und dem Chassis-Ground andererseits.

Hierbei ist vorgesehen, dass die aktive Isolationsüberwachungseinrichtung die Frequenz der in das Bordnetz eingekoppelten Messimpulse in Abhängigkeit von der ermittelten Ableitkapazität adaptiert. So ist beispielsweise aus EP 2 717 063 A1 eine aktive Isolationsüberwachung mit einem Mehrfrequenzverfahren bekannt, so dass der Inhalt dieser Patentanmeldung der vorliegenden Beschreibung hinsichtlich der Anpassung der Frequenz der Messimpulse zuzurechnen ist.

Es wurde bereits vorstehend kurz erwähnt, dass die zur Strommessung dienende Messeinrichtung des Sensors vorzugsweise gemäß der Vierleitertechnik arbeitet, wie sie beispielsweise in EP 0 605 800 A1 beschrieben ist. Der Sensor weist deshalb vorzugsweise zwei Stromanschlüsse auf, um den zu messenden Bordnetzstrom in den Sensor einzuleiten bzw. von dem Sensor abzuführen. Die Messeinrichtung misst dann den Bordnetzstrom beispielsweise gemäß der Vierleitertechnik.

Die aktive Isolationsüberwachung erfordert eine Spannungsmessung an verschiedenen Messstellen innerhalb des Bordnetzes.

Hierzu weist der erfindungsgemäße Sensor zunächst einen ersten Spannungsmessanschluss auf, um die Spannung an einer ersten Messstelle des Bordnetzes an der High-Side hinter einem schaltbaren High-Side-Schütz zu messen. Hierbei ist zu erwähnen, dass sich die Begriffe "vor" und "hinter" auf die Perspektive der Batterie beziehen, d.h. die erste Messstelle befindet sich aus der Perspektive der Batterie hinter dem schaltbaren High-Side-Schütz. Die erste Messstelle befindet sich in dem Bordnetz an der High-Side also vorzugsweise zwischen dem High-Side-Schütz und dem Verbraucher (z.B. Inverter). Weiterhin ist zu erwähnen, dass das High-Side-Schütz vorzugsweise in einem Hauptpfad angeordnet ist, wobei parallel zu dem Hauptpfad ein Nebenpfad verläuft, der zur Strombegrenzung bei einem Einschaltvorgang dient und einen Trennschalter und einen Widerstand ("Pre-charge resistor") enthält. Die erste Messstelle für die aktive Isolationsüberwachung befindet sich dann vorzugsweise in dem Hauptpfad.

Darüber hinaus weist der erfindungsgemäße Sensor einen zweiten Spannungsmessanschluss auf, um die Spannung an einer zweiten Messstelle an der Low-Side des Bordnetzes hinter einem schaltbaren Low-Side-Schütz zu messen. Die zweite Messstelle für die aktive Isolationsüberwachung befindet sich in dem Bordnetz an der Low-Side also vorzugsweise zwischen dem Low-Side-Schütz und dem Verbraucher (z.B. Inverter).

Weiterhin verfügt der Sensor vorzugsweise über einen dritten Spannungsmessanschluss zur Spannungsmessung an einer dritten Messstelle an der High-Side des Bordnetzes zwischen der Batterie und dem High-Side-Schütz. Vorzugsweise weist das Bordnetz an der High-Side eine Sicherung auf. Die dritte Messstelle für die aktive Isolationsüberwachung liegt dann an der High-Side vorzugsweise zwischen der Batterie und der Sicherung.

Die Spannungsmessung an diesen drei Messstellen innerhalb des Bordnetzes ermöglicht eine aktive Isolationsüberwachung, wobei Ableitkapazitäten und Ableitwiderstände zwischen der Low-Side und/oder der High-Side einerseits und dem Chassis-Ground andererseits aus den Spannungsmesswerten abgeleitet werden können. Die Berechnung der Ableitkapazität bzw. der Ableitwiderstände ist grundsätzlich von den bekannten Verfahren zur aktiven Isolationsüberwachung bekannt. Beispielsweise wird hierzu auf EP 0 654 673 B1, EP 2 256 506 B1 und DE 10 2018 117 296 B4 hingewiesen, so dass eine detaillierte Beschreibung der Berechnung der Ableitungswiderstände bzw. Ableitkapazitäten in an dieser Stelle entbehrlich ist.

In dem bevorzugten Ausführungsbeispiel der Erfindung weist der Sensor einen steuerbaren, hochspannungsfesten ersten Trennschalter an dem ersten Spannungsmessanschluss an der High-Side auf. Der erste Trennschalter ermöglicht wahlweise eine Messabfrage an dem ersten Spannungsmessanschluss oder eine Abtrennung des ersten Spannungsmessanschlusses.

Darüber hinaus weist der erfindungsgemäße Sensor vorzugsweise eine steuerbaren, hochspannungsfesten zweiten Trennschalter an dem zweiten Spannungsmessanschluss auf, wobei der zweite Trennschalter wahlweise eine Messabfrage an dem zweiten Spannungsmessanschluss oder eine Abtrennung des zweiten Spannungsmessanschlusses ermöglicht.

Es wurde bereits vorstehend erwähnt, dass im Rahmen der aktiven Isolationsüberwachung Messimpulse in das Bordnetz eingekoppelt werden. Hierzu weist der erfindungsgemäße Sensor in dem bevorzugten Ausführungsbeispiel einen Ankopplungsausgang auf, um den Sensor an das Chassis-Ground des Fahrzeugs ankoppeln zu können, wobei der Ankopplungsausgang des Sensors vorzugsweise hochohmig ist.

Zur Erzeugung der Messimpulse für die aktive Isolationsüberwachung weist der Sensor in dem bevorzugten Ausführungsbeispiel eine Impulsspannungsquelle auf, wobei die Impulsspannungsquelle bei der aktiven Isolationsüberwachung die Messimpulse erzeugt und an dem Ankopplungsausgang des Sensors ausgibt.

Optional kann der Sensor hierbei einen steuerbaren, hochspannungsfesten dritten Trennschalter an dem Ankopplungsausgang des Sensors aufweisen, wobei der dritte Trennschalter die Impulsspannungsquelle wahlweise an das Chassis-Ground ankoppelt oder von dem Chassis-Ground trennt.

Weiterhin enthält der Sensor in dem bevorzugten Ausführungsbeispiel eine Recheneinheit zur Berechnung mindestens eines Widerstandswerts und eines Kapazitätswerts im Rahmen der aktiven Isolationsüberwachung. Die Art und Weise der Berechnung der Ableitwiderstände und/oder der Ableitkapazitäten ist in den bereits vorstehend erwähnten Patentanmeldungen EP 0 654 673 B1, EP 2 256 506 B1 und DE 10 2018 117 296 B4 beschrieben, so dass eine detaillierte Beschreibung der Berechnung an dieser Stelle entbehrlich ist.

Beispielsweise kann die Recheneinheit in Abhängigkeit von den Spannungsmesswerten und den Messimpulsen der Impulsspannungsquelle folgende Größen berechnen:
- Einen ersten Ableitwiderstand zwischen der High-Side des Bordnetzes vor dem High-Side-Schütz einerseits und dem Chassis-Sound des Fahrzeugs andererseits.
- Eine erste Ableitkapazität zwischen der High-Side des Bordnetzes vor dem High-Side-Schütz einerseits und dem Chassis-Ground des Fahrzeugs andererseits.
- Einen zweiten Ableitwiderstand zwischen der Low-Side des Bordnetzes vor dem Low-Side-Schütz einerseits und dem Chassis-Ground des Fahrzeugs andererseits.
- Eine zweite Ableitkapazität zwischen der Low-Side des Bordnetzes vor dem Low-Side-Schütz einerseits und dem Chassis-Ground des Fahrzeugs andererseits.
- Einen dritten Ableitwiderstand zwischen der High-Side des Bordnetzes hinter dem High-Side-Schütz einerseits und dem Chassis-Ground des Fahrzeugs andererseits.
- Eine dritte Ableitkapazität zwischen der High-Side des Bordnetzes hinter dem High-Side-Schütz einerseits und dem Chassis-Ground des Fahrzeugs andererseits.
- Einen vierten Ableitwiderstand zwischen der Low-Side des Bordnetzes hinter dem Low-Side-Schütz einerseits und dem Chassis-Ground und des Fahrzeugs andererseits.
- Eine vierte Ableitkapazität zwischen der Low-Side des Bordnetzes hinter dem Low-Side-Schütz einerseits und dem Chassis-Ground des Fahrzeugs andererseits.

Im Rahmen der Erfindung können also vorzugsweise sowohl im DC-Pack als auch im DC-Link Ableitwiderstände und Ableitkapazitäten gegenüber Chassis-Ground ermittelt und zwar getrennt für High-Side und Low-Side des Bordnetzes.

Die Kombination der Ergebnisse der Isolationsüberwachung in Zusammenhang mit den Ergebnissen der Spannungsmessung an den drei Messstellen ermöglicht bei einem elektrisch angetriebenen Kraftfahrzeug eine Aussage über das Isolationsniveau innerhalb der HV-Batterie oder im Antriebsstrang sowie eine Aussage über die Polarität des Isolationsfehlers auf der DC-Link-Seite (HV-Pos oder HV-Neg). Neben der Messung der Isolation auf der DC-Pack-Seite (während geöffneter Hauptschütze und bei geöffnetem Schalter in dem Nebenpfad parallel zu dem High-Side-Schütz sowie bei geöffneten Trennschaltern in den Messpfaden für die erste und zweie Messstelle) ermittelt die Isolationsüberwachungseinrichtung zusätzlich zum Gesamt-Isolationswiderstand der HV-Pack-Seite in Kombination mit der gemessenen Spannung an der dritten Messstelle die Polarität des Isolationsfehlers bzgl. HV-Pos/HV-Neg sowie die separaten Werte Ableitwiderstände gegenüber Chassis-Ground innerhalb der HV-Pack Seite. Werden nun die Hauptschütze geschlossen, erfolgt zum einen die Ermittlung des Isolationswertes für das gesamte Fahrzeug als resultierender Parallelwert von HV-Pack und HV Link sowie unter Berücksichtigung der gemessenen Spannung an der dritten Messstelle die Polarität des Isolationsfehlers bzgl. HV-Pos/HV-Neg sowie die separaten Werte der Ableitwiderstände, so dass auch hinter den Schützen die Ableitwiderstände gegenüber Chassis-Ground berechnet werden können.

Die vorstehend genannten drei Spannungsmessanschlüsse dienen der aktiven Isolationsüberwachung, wie vorstehend beschrieben wurde. Darüber hinaus kann der Sensor jedoch auch weitere Spannungsmessanschlüsse aufweisen, die die Spannung in dem Bordnetz an anderen Messstellen messen.

Beispielsweise kann ein vierter Spannungsmessanschluss vorgesehen sein, um die Spannung in dem Bordnetz an einer vierten Messstelle an der High-Side des Bordnetzes vor dem schaltbaren High-Side-Schütz zu messen. Bei dem bevorzugten Ausführungsbeispiel befindet sich die vierte Messstelle an der High-Side hinter der Sicherung und vor der vorstehend erwähnten Abzweigung in den Hauptpfad und den zur Strombegrenzung dienenden Nebenpfad.

Weiterhin kann ein fünfter Spannungsmessanschluss vorgesehen sein, um die Spannung an einer fünften Messstelle in dem vorstehend erwähnten Nebenpfad zu messen, der parallel zu dem schaltbaren High-Side-Schütz an der High-Side des Bordnetzes verläuft. Derartige Nebenpfade parallel zu dem schaltbaren High-Side-Schütz sind an sich aus dem Stand der Technik bekannt und ermöglichen einen weichen Einschaltvorgang beim Einschalten des High-Side-Schützes. Hierzu wird zunächst der Schalter in dem Nebenpfad geschlossen, in dem ein Widerstand ("Pre-charge resistor") den Strom begrenzt. Erst anschließend wird dann das High-Side-Schütz geschlossen.

Weiterhin kann der Sensor einen sechsten Spannungsmessanschluss aufweisen, um die Spannung an einer sechsten Messstelle an der Low-Side des Bordnetzes vor dem schaltbaren Low-Side-Schütz zu messen. Die sechste Messstelle befindet sich an der Low-Side vorzugsweise zwischen der Sicherung und dem Low-Side-Schütz.

Diese drei weiteren Spannungsmessanschlüsse können anderen Zwecken dienen als der aktiven Isolationsüberwachung.

Ferner ist zur bemerken, dass die Integration des Sensors zur Strom-/Spannungsmessung einerseits und der aktiven Isolationsüberwachungseinrichtung andererseits in einer gemeinsamen integrierten Schaltung ("Chip") erfolgen kann. Es ist jedoch auch möglich, dass beide Komponenten (Sensor zur Strom-/Spannungsmessung und aktive Isolationsüberwachungseinrichtung) lediglich auf einer gemeinsamen Leiterplatte oder auch nur in einem gemeinsamen Gehäuse angeordnet sind.

Weiterhin ist zu erwähnen, dass die Erfindung nicht nur Schutz beansprucht für den vorstehend beschriebenen erfindungsgemäßen Sensor als ein einzelnes Bauteil. Vielmehr beansprucht die Erfindung auch Schutz für ein Batteriemanagementsystem (BMS) für ein Bordnetz eines elektrisch angetriebenen Fahrzeugs mit einem solchen erfindungsgemäßen Sensor. Das Batteriemanagementsystem umfasst dann auch die Messpfade zwischen den Spannungsmessanschlüssen des Sensors und den zugehörigen Messstellen. Darüber hinaus umfasst das Batteriemanagementsystem dann auch einen Ankopplungspfad zwischen dem Ankopplungsausgang des Sensors und dem Chassis-Ground des Fahrzeugs.

Ferner ist zu erwähnen, dass die Erfindung auch Schutz beansprucht für ein komplettes Bordnetz eines Fahrzeugs mit einem solchen Batteriemanagementsystem mit dem erfindungsgemäßen Sensor. Das Bordnetz kann beispielsweise auch folgende weitere Komponenten enthalten:
- Eine Batterie zum Speisen des Bordnetzes, wobei die Batterie vorzugsweise wieder aufladbaren ist.
- Eine Entladeschaltung zwischen der High-Side und der Low-Side des Bordnetzes hinter dem High-Side-Schütz und dem Low-Side-Schütz.
- Einen Inverter.

Schließlich beansprucht die Erfindung auch Schutz für ein komplettes Fahrzeug (z.B. Elektroauto) mit einem solchen Bordnetz, das mit dem Batteriemanagementsystem mit dem erfindungsgemäßen Sensor ausgestattet ist.

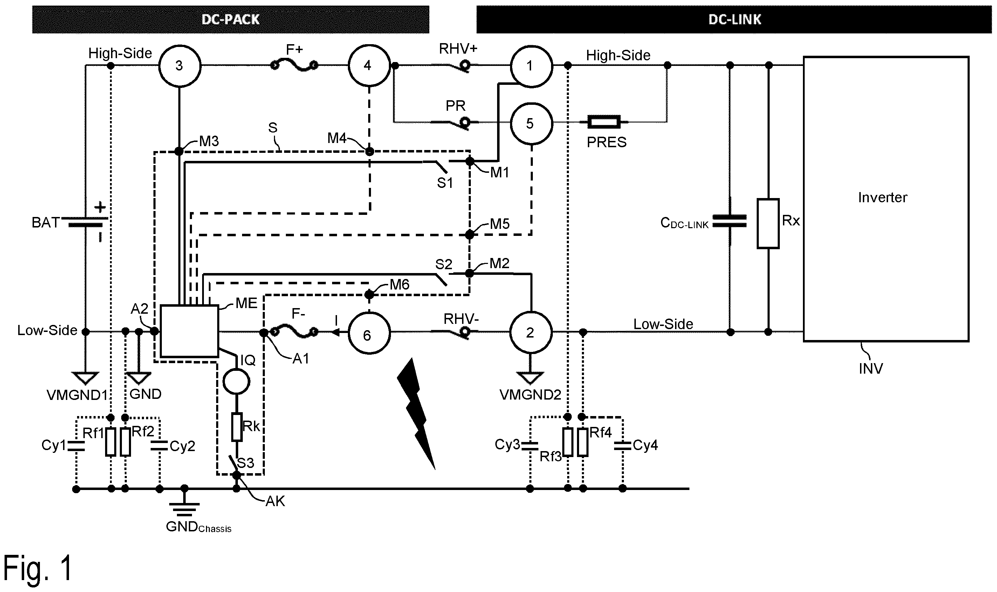

Figur 1 zeigt ein Schaltbild eines erfindungsgemäßen Bordnetzes für ein elektrisch angetriebenes Kraftfahrzeug.

Das Bordnetz verbindet ein DC-Pack des elektrisch angetriebenen Kraftfahrzeugs mit einem DC-Link, wie an sich aus dem Stand der Technik bekannt ist. Das DC-Pack ist hierbei über zwei schaltbare Schütze RHV+, RHV- an einer High-Side bzw. an einer Low-Side mit dem DC-Link verbunden.

Das Bordnetz wird hierbei von einer wiederaufladbaren Batterie BAT gespeist, wobei ein Pluspol + der Batterie BAT mit der High-Side des Bordnetzes verbunden ist, während ein Minuspol - der Batterie BAT mit der Low-Side des Bordnetzes verbunden ist. Die Low-Side des Bordnetzes bildet hierbei also eine Batteriemasse, die durch die Symbole GND, VMGND1, VMGMD2 dargestellt ist. Hiervon zu unterscheiden ist jedoch ein Chassis-Ground GND_{Chassis}, das normalerweise nicht mit dem Bordnetz verbunden ist.

In dem Bordnetz befinden sich in dem DC-Pack sowohl an der High-Side als auch an der Low-Side Sicherungen F+, F-, was an sich aus dem Stand der Technik bekannt ist.

Weiterhin ist zu erwähnen, dass parallel zu dem schaltbaren Schütz RHV+ an der High-Side des Bordnetzes ein Nebenpfad geschaltet ist, der zum einen einen Widerstand PRES ("pre-charge resistor") enthält und zum anderen einen Trennschalter PR. Vor dem Einschalten der beiden Schütze RHV+, RHV- wird zunächst der Trennschalter PR geschlossen, wobei dann zunächst ein kleinerer Strom über den Nebenpfad fließt. Erst anschließend wird dann das Schütz RHV+ geschlossen. Dieses schrittweise Schließen des Trennschalters PR und des Schützes RHV+ verhindert bei einem Einschaltvorgang einen zu starken plötzlichen Stromanstieg in dem Bordnetz.

In dem DC-Link ist zwischen der High-Side und der High-Side ein Pufferkondensator C_{DC-Link} geschaltet.

Weiterhin ist in dem DC-Link zwischen der High-Side und der High-Side eine Entladeschaltung Rx geschaltet, die hier nur schematisch dargestellt ist.

Schließlich speist das Bordnetz einen Inverter INV, der hier ebenfalls nur schematisch dargestellt ist.

In dem Bordnetz befindet sich nun ein erfindungsgemäße Sensor S, der zwei Funktionen hat. Zum einen ermöglicht der Sensor S die Messung eines Bordnetzstroms I gemäß der Vierleitertechnik. Zum anderen ermöglicht der Sensor S auch eine aktive Isolationsüberwachung, wobei die beiden Funktionen nachfolgend beschrieben werden.

Zur Strommessung weist der Sensor S zwei Stromanschlüsse A1, A2 auf, um den zu messenden Bordnetzstrom I in den Sensor S einzuleiten bzw. von dem Sensor S abzuführen. Eine Messeinrichtung ME misst dann den Bordnetzstrom I in dem Sensor S, wobei die Messeinrichtung beispielsweise gemäß der Vierleitertechnik arbeiten kann, wie sie aus EP 0 605 800 A1 bekannt ist.

Darüber hinaus weist der Sensor S zur aktiven Isolationsüberwachung drei Spannungsmessanschlüsse M1, M2 und M3 auf, die die Spannung in dem Bordnetz an drei Messstellen 1, 2 bzw. 3 messen.

Zur aktiven Isolationsüberwachung weist der Sensor S auch eine Impulsspannungsquelle IQ auf, die über einen Ankopplungswiderstand Rk und einen steuerbaren Schalter S3 Messimpulse an einem Ankopplungsausgang AK ausgibt, wobei der Ankopplungsausgang AK mit dem Chassis-Ground GND-_{Chassis} verbunden ist. Die Messeinrichtung ME kann dann aus den Spannungsmesswerten an den Messstellen 1, 2, 3 folgende Ableitwiderstände bzw. Ableitkapazitäten berechnen:
- Einen ersten Ableitwiderstand Rf1 zwischen der High-Side des Bordnetzes vor dem High-Side-Schütz RHV+ einerseits und dem Chassis-Ground GND_{CHASSIS} des Fahrzeugs andererseits.
- Eine erste Ableitkapazität Cy1 zwischen der High-Side des Bordnetzes vor dem High-Side-Schütz RHV+ einerseits und dem Chassis-Ground GND_{CHASSIS} des Fahrzeugs andererseits.
- Einen zweiten Ableitwiderstand Rf2 zwischen der Low-Side des Bordnetzes vor dem Low-Side-Schütz RHV- einerseits und dem Chassis-Ground GND_{CHASSIS} des Fahrzeugs andererseits.
- Eine zweite Ableitkapazität Cy2 zwischen der Low-Side des Bordnetzes vor dem Low-Side-Schütz RHV- einerseits und dem Chassis-Ground GND_{CHASSIS} des Fahrzeugs andererseits.
- Einen dritten Ableitwiderstand Rf3 zwischen der High-Side des Bordnetzes hinter dem High-Side-Schütz RHV+ einerseits und dem Chassis-Ground GND_{CHASSIS} des Fahrzeugs andererseits.
- Eine dritte Ableitkapazität Cy3 zwischen der High-Side des Bordnetzes hinter dem High-Side-Schütz RHV- einerseits und dem Chassis-Ground GND_{CHASSIS} des Fahrzeugs andererseits.
- Einen vierten Ableitwiderstand Rf4 zwischen der Low-Side des Bordnetzes hinter dem Low-Side-Schütz RHV- einerseits und dem Chassis-Ground GND_{CHASSIS} und des Fahrzeugs andererseits.
- Eine vierte Ableitkapazität Cy4 zwischen der Low-Side des Bordnetzes hinter dem Low-Side-Schütz RHV- einerseits und dem Chassis-Ground GND_{CHASSIS} des Fahrzeugs andererseits.

Die Berechnung der Ableitwiderstände Rf1, Rf2, Rf3, Rf4 und der Ableitkapazitäten Cy1, Cy2, Cy3, Cy4 kann in herkömmlicher Weise erfolgen, wie beispielsweise in EP 0 654 673 B1, EP 2 256 506 B1 und DE 10 2018 117 296 B4 erläutert ist.

Darüber hinaus weist der Sensor S mehrere Trennschalter S1, S2, S3 auf, die hochspannungsfest sind und eine Abtrennung der Spannungsmessanschlüsse M1, M3, M3 bzw. des Ankopplungsausgangs AK ermöglichen.

Schließlich weist der Sensor S noch drei weitere Spannungsmessanschlüsse M4, M5, M6 auf, die eine Spannungsmessung an drei weiteren Messstellen 4, 5, 6 innerhalb des Bordnetzes ermöglichen. Die Spannungsmessung an den Messstellen M4, M5, M6 ist jedoch optional und hat nichts mit der aktiven Isolationsüberwachung zu tun.

### Bezugszeichenliste:

- 1: Erste Messstelle an der High-Side des Bordnetzes hinter dem schaltbaren Schütz RHV+
- 2: Zweite Messstelle an der Low-Side des Bordnetzes hinter dem schaltbaren Schütz RHV-
- 3 4: Dritte Messstelle an der High-Side des Bordnetzes vor dem schaltbaren Schütz RHV+ Vierte Messstelle an der High-Side des Bordnetzes vor dem schaltbaren Schütz RHV+
- 5: Fünfte Messstelle an der High-Side des Bordnetzes in dem Nebenpfad parallel zu dem schaltbaren Schütz RHV+
- 6: Sechste Messstelle an der Low-Side des Bordnetzes vor dem schaltbaren Schütz
- A1: Stromanschluss zum Einleiten des Bordnetzstroms in den Sensor
- A2: Stromanschluss zum Abführen des Bordnetzstroms aus dem Sensor
- AK: Ankopplungsausgang des Sensors
- BAT: Akkumulator
- C_{DC-LINK}: Pufferkondensator
- Cy1: Ableitkapazität zwischen High-Side des Bornetzes vor dem schaltbaren Schütz und Chassis-Ground GND_{Chassis}
- Cy2: Ableitkapazität zwischen Low-Side des Bornetzes vor dem schaltbaren Schütz und Chassis-Ground GND_{Chassis}
- Cy3: Ableitkapazität zwischen High-Side des Bornetzes hinter dem schaltbaren Schütz und Chassis-Ground GND_{Chassis}
- Cy4: Ableitkapazität zwischen Low-Side des Bornetzes hinter dem schaltbaren Schütz und Chassis-Ground GND_{Chassis}
- F-: Sicherung an der Low-Side des Bordnetzes
- F+: Sicherung an der High-Side des Bordnetzes
- GND: Batteriemasse
- GND_{Chassis}: Chassis-Ground
- I: Bordnetzstrom
- INV: Inverter
- IQ: Impulsspannungsquelle
- M1-M6: Spannungsmessanschlüsse des Sensors
- ME: Messeinrichtung des Sensors
- +: Pluspol der Batterie BAT
- -: Minuspol der Batterie BAT
- PR: Schalter in dem Nebenpfad parallel zu dem schaltbaren Schütz RHV+
- PRES: Widerstand in dem Nebenpfad parallel zu dem schaltbaren Schütz RHV+
- RHV-: Schaltbares Schütz an der Low-Side des Bordnetzes
- RHV+: Schaltbares Schütz an der High-Side des Bordnetzes
- Rk: Ankopplungswiderstand
- Rx: Entladeschaltung
- Ry1: Ableitwiderstand zwischen High-Side des Bornetzes vor dem schaltbaren Schütz und Chassis-Ground GND_{Chassis}
- Ry2: Ableitwiderstand zwischen Low-Side des Bornetzes vor dem schaltbaren Schütz und Chassis-Ground GND_{Chassis}
- Ry3: Ableitwiderstand zwischen High-Side des Bornetzes hinter dem schaltbaren Schütz und Chassis-Ground GND_{Chassis}
- Ry4: Ableitwiderstand zwischen Low-Side des Bornetzes hinter dem schaltbaren Schütz und Chassis-Ground GND_{Chassis}
- S: Sensor
- S1-S3: Steuerbare Trennschalter
- VMGND1: Batteriemasse
- VMGND2: Batteriemasse

## Patentansprüche

1. Sensor (S) für ein elektrisches Netz mit einer High-Side zur Verbindung mit einem positiven Pol (+) einer Batterie (BAT), einer Low-Side zur Verbindung mit einem negativen Pol (+) der Batterie (BAT) und einem Chassis-Ground (GND_{CHASSIS}), insbesondere für ein elektrisches Bordnetz eines elektrisch angetriebenen Fahrzeugs, insbesondere in einem Elektroauto, mit
a) einer Messeinrichtung (ME) zur Strommessung und/oder zur Spannungsmessung in dem elektrischen Netz, insbesondere mit einem niederohmigen Strommesswiderstand zur Strommessung gemäß der Vierleitertechnik, und
b) einer integrierten Isolationsüberwachungseinrichtung (ME, IQ, Rk, S3) zur Überwachung einer elektrischen Isolation von High-Side und/oder Low-Side des elektrischen Netzes, wobei die Isolationsüberwachungseinrichtung (ME, IQ, Rk, S3)
b1) aktiv arbeitet und zur Isolationsüberwachung AC-Messimpulse in das elektrische Netz einprägt, und
b2) kapazitiv oder resistiv an das elektrische Netz angekoppelt ist,
**dadurch gekennzeichnet,**
c) **dass** die aktive Isolationsüberwachungseinrichtung (ME, IQ, Rk, S3) eine Ableitkapazität (Cy1, Cy2, Cy3, Cy4) ermittelt zwischen der Low-Side und/oder der High-Side des elektrischen Netzes einerseits und dem Chassis-Ground (GND_{CHASSIS}) des elektrischen Netzes andererseits, und
d) **dass** die aktive Isolationsüberwachungseinrichtung (ME, IQ, Rk, S3) die Frequenz der Messimpulse in Abhängigkeit von der ermittelten Ableitkapazität (Cy1, Cy2, Cy3, Cy4) adaptiert.

2. Sensor (S) nach Anspruch 1, **gekennzeichnet durch**
a) einen ersten Stromanschluss (A1) zum Einleiten eines Netzstroms (I) des elektrischen Netzes in den Sensor (S),
b) einen zweiten Stromanschluss (A2) zum Abführen des Netzstroms (I) des elektrischen Netzes aus dem Sensor (S),
c) wobei die Messeinrichtung (ME) den Netzstrom (I) misst.

3. Sensor (S) nach einem der vorhergehenden Ansprüche, **gekennzeichnet durch**
a) einen ersten Spannungsmessanschluss (M1) zur Spannungsmessung an einer ersten Messstelle (1) an der High-Side des elektrischen Netzes hinter einem schaltbaren High-Side-Schütz (RHV+) an der High-Side des elektrischen Netzes, und
b) einen zweiten Spannungsmessanschluss (M2) zur Spannungsmessung an einer zweiten Messstelle (2) an der Low-Side des elektrischen Netzes hinter einem schaltbaren Low-Side-Schütz (RHV-) an der Low-Side des elektrischen Netzes, und
c) einen dritten Spannungsmessanschluss (M3) zur Spannungsmessung an einer dritten Messstelle (3) an der High-Side des elektrischen Netzes zwischen der Batterie (BAT) und dem High-Side-Schütz (RHV+) an der High-Side des elektrischen Netzes.

4. Sensor (S) nach Anspruch 3, **gekennzeichnet durch**
a) einen steuerbaren, hochspannungsfesten ersten Trennschalter (S1) an dem ersten Spannungsmessanschluss (M1), wobei der erste Trennschalter (S1) wahlweise eine Messabfrage an dem ersten Spannungsmessanschluss (M1) ermöglicht oder den ersten Spannungsmessanschluss (M1) abtrennt, und/oder
b) einen steuerbaren, hochspannungsfesten zweiten Trennschalter (S2) an dem zweiten Spannungsmessanschluss (M2), wobei der zweite Trennschalter (S2) wahlweise eine Messabfrage an dem zweiten Spannungsmessanschluss (M2) ermöglicht oder den zweiten Spannungsmessanschluss (M2) abtrennt.

5. Sensor (S) nach einem der vorhergehenden Ansprüche, **gekennzeichnet durch**
a) einen Ankopplungsausgang (AK) zur Ankopplung des Sensors (S) an ein Chassis-Ground (GND-_{CHASSIS}), insbesondere an dem Fahrzeug, wobei der Ankopplungsausgang (AK) vorzugsweise hochohmig ist,
b) eine Impulsspannungsquelle (IQ) zur aktiven Isolationsüberwachung, wobei die Impulsspannungsquelle (IQ) bei der aktiven Isolationsüberwachung die Messimpulse erzeugt und an dem Ankopplungsausgang (AK) ausgibt,
c) optional einen steuerbaren, hochspannungsfesten dritten Trennschalter (S3) an dem Ankopplungsausgang (AK) des Sensors (S), wobei der dritte Trennschalter (S3) die Impulsspannungsquelle (IQ) wahlweise an das elektrische Netz ankoppelt oder von dem elektrischen Netz trennt.

6. Sensor (S) nach Anspruch 5, **gekennzeichnet durch** eine Recheneinheit zur Berechnung mindestens eines Widerstandswerts (Rf1, Rf2, Rf3, Rf4) und/oder eines Kapazitätswerts (Cy1, Cy2, Cy3, Cy4) im Rahmen der Isolationsüberwachung.

7. Sensor (S) nach Anspruch 6, **dadurch gekennzeichnet,**
a) **dass** die Recheneinheit in Abhängigkeit von dem Spannungsmesswert an mindestens einem der Spannungsmessanschlüsse (M1-M3) und den Messimpulsen der Impulsspannungsquelle (IQ) folgende Größen berechnet:
a1) einen ersten Widerstand (Rf1) zwischen der High-Side des elektrischen Netzes vor dem High-Side-Schütz (RHV+) einerseits und dem Chassis-Ground (GND_{CHASSIS}) andererseits, und/oder
a2) eine erste Kapazität (Cy1) zwischen der High-Side des elektrischen Netzes vor dem High-Side-Schütz (RHV+) einerseits und dem Chassis-Ground (GND_{CHASSIS}) andererseits, und/oder
b) **dass** die Recheneinheit in Abhängigkeit von dem Spannungsmesswert an mindestens einem der Spannungsmessanschlüsse (M1-M3) und den Messimpulsen der Impulsspannungsquelle (IQ) folgende Größen berechnet:
b1) einen zweiten Widerstand (Rf2) zwischen der Low-Side des elektrischen Netzes vor dem Low-Side-Schütz (RHV-) einerseits und dem Chassis-Ground (GND_{CHASSIS}) andererseits, und/oder
b2) eine zweite Kapazität (Cy2) zwischen der Low-Side des elektrischen Netzes vor dem Low-Side-Schütz (RHV-) einerseits und dem Chassis-Ground (GND_{CHASSIS}) andererseits, und/oder
c) **dass** die Recheneinheit in Abhängigkeit von dem Spannungsmesswert an mindestens einem der Spannungsmessanschlüsse (M1-M3) und den Messimpulsen der Impulsspannungsquelle (IQ) folgende Größen berechnet:
c1) einen dritten Widerstand (Rf3) zwischen der High-Side des elektrischen Netzes hinter dem High-Side-Schütz (RHV+) einerseits und dem Chassis-Ground (GND_{CHASSIS}) andererseits, und/oder
c2) eine dritte Kapazität (Cy3) zwischen der High-Side des elektrischen Netzes hinter dem High-Side-Schütz (RHV+) einerseits und dem Chassis-Ground (GND_{CHASSIS}) andererseits, und/oder
d) **dass** die Recheneinheit in Abhängigkeit von dem Spannungsmesswert an mindestens einem der Spannungsmessanschlüsse (M1-M3) und den Messimpulsen der Impulsspannungsquelle (IQ) folgende Größen berechnet:
d1) einen vierten Widerstand (Rf4) zwischen der Low-Side des elektrischen Netzes hinter dem Low-Side- Schütz (RHV-) einerseits und dem Chassis-Ground (GND_{CHASSIS}) andererseits, und/oder
d2) eine vierte Kapazität (Cy4) zwischen der Low-Side des elektrischen Netzes hinter dem Low-Side-Schütz (RHV-) einerseits und dem Chassis-Ground (GND_{CHASSIS}) andererseits.

8. Sensor (S) nach einem der vorhergehenden Ansprüche, **gekennzeichnet durch**
a) einen vierten Spannungsmessanschluss (M4) zur Spannungsmessung an einer vierten Messstelle (4) an der High-Side des elektrischen Netzes vor dem schaltbaren High-Side-Schütz (RHV+) an der High-Side des elektrischen Netzes,
b) einen fünften Spannungsmessanschluss (M5) zur Spannungsmessung an einer fünften Messstelle (5) in einem Nebenpfad, der parallel zu dem schaltbaren High-Side-Schütz (RHV+) an der High-Side des elektrischen Netzes verläuft, und/oder
c) einen sechsten Spannungsmessanschluss (M6) zur Spannungsmessung an einer sechsten Messstelle (6) an der Low-Side des elektrischen Netzes vor dem schaltbaren Low-Side-Schütz (RHV-) an der Low-Side des elektrischen Netzes.

9. Batteriemanagementsystem für ein elektrisches Netz, insbesondere für ein Bordnetz eines elektrisch angetriebenen Fahrzeugs, mit
a) dem Sensor (S) nach einem der Ansprüche 3 bis 8,
b) einem ersten Messpfad von dem ersten Spannungsmessanschluss (M1) des Sensors (S) zu der ersten Messstelle (1) an der High-Side des elektrischen Netzes hinter dem High-Side-Schütz (RHV+),
c) einem zweiten Messpfad von dem zweiten Spannungsmessanschluss (M2) des Sensors (S) zu der zweiten Messstelle (2) an der Low-Side des elektrischen Netzes hinter dem Low-Side-Schütz (RHV-),
d) einem dritten Messpfad von dem dritten Spannungsmessanschluss (M3) des Sensors (S) zu der dritten Messstelle (3) an der High-Side des elektrischen Netzes vor dem High-Side-Schütz (RHV+), und
e) einem Ankopplungspfad zwischen dem Ankopplungsausgang (AK) des Sensors (S) und dem Chassis-Ground (GND_{CHASSIS}).

10. Elektrisches Netz, insbesondere Bordnetz eines Fahrzeugs mit einem Batteriemanagementsystem nach Anspruch 9, insbesondere mit folgenden weiteren Komponenten:
a) einer Batterie (BAT) zum Speisen des elektrischen Netzes, wobei die Batterie (BAT) vorzugsweise wiederaufladbar ist, und/oder
b) einer Entladeschaltung (Rx) zwischen der High-Side und der Low-Side des elektrischen Netzes hinter dem High-Side-Schütz (RHV+) und hinter dem Low-Side-Schütz (RHV-), und/oder
c) einem Inverter (INV), der von der High-Side und der Low-Side des elektrischen Netzes gespeist wird.

11. Fahrzeug, insbesondere Elektroauto, mit einem Bordnetz nach Anspruch 10.

## Claims

1. Sensor (S) for an electrical network with a high-side for connection with a positive pole (+) of a battery (BAT), a low-side for connection with a negative pole (-) of the battery (BAT) and a chassis ground (GND_{CHASSIS}), in particular for an electrical on-board network of an electrically driven vehicle, in particular in an electric car, comprising
a) a measuring device (ME) for current measurement and/or for voltage measurement in the electrical network, in particular with a low-resistance current sense resistor for current measurement according to the four-wire technique, and
b) an integrated insulation monitoring device (ME, IQ, Rk, S3) for monitoring electrical insulation of high-side and/or low-side of the electrical network, wherein the insulation monitoring device (ME, IQ, Rk, S3)
b1) operates actively and impresses AC measurement pulses into the electrical network for insulation monitoring, and
b2) is capacitively or resistively coupled to the electrical network,
**characterized in**
c) **that** the active insulation monitoring device (ME, IQ, Rk, S3) determines a leakage capacitance (Cy1, Cy2, Cy3, Cy4) between the low-side and/or the high-side of the electrical network on the one hand and the chassis ground (GND_{CHASSIS}) of the electrical network on the other hand, and
d) **that** the active insulation monitoring device (ME, IQ, Rk, S3) adapts the frequency of the measurement pulses as a function of the leakage capacitance (Cy1, Cy2, Cy3, Cy4) determined.

2. Sensor (S) according to claim 1, **characterized by**
a) a first current connection (A1) for introducing a mains current (I) of the electrical network into the sensor (S),
b) a second current connection (A2) for discharging the mains current (I) of the electrical network from the sensor (S),
c) wherein the measuring device (ME) measures the mains current (I).

3. Sensor (S) according to any of the preceding claims, **characterized by**
a) a first voltage measuring terminal (M1) for voltage measurement at a first measuring point (1) on the high side of the electrical network downstream of a switchable high-side contactor (RHV+) on the high side of the electrical network, and
b) a second voltage measuring terminal (M2) for voltage measurement at a second measuring point (2) on the low side of the electrical network downstream of a switchable low-side contactor (RHV-) on the low side of the electrical network, and
c) a third voltage measuring terminal (M3) for voltage measurement at a third measuring point (3) on the high-side of the electrical network between the battery (BAT) and the high-side contactor (RHV+) on the high-side of the electrical network.

4. Sensor (S) according to claim 3, **characterized by**
a) a controllable, high-voltage-proof first disconnect switch (S1) at the first voltage measurement terminal (M1), the first disconnect switch (S1) selectively enabling measurement sensing at the first voltage measurement terminal (M1) or disconnecting the first voltage measurement terminal (M1), and/or
b) a controllable, high-voltage-proof second disconnect switch (S2) at the second voltage measurement terminal (M2), the second disconnect switch (S2) optionally enabling a measurement interrogation at the second voltage measurement terminal (M2) or disconnecting the second voltage measurement terminal (M2).

5. Sensor (S) according to any of the preceding claims, **characterized by**
a) a coupling output (AK) for coupling the sensor (S) to a chassis ground (GND_{CHASSIS}), in particular to the vehicle, wherein the coupling output (AK) is preferably high-impedance,
b) a pulse voltage source (IQ) for active insulation monitoring, the pulse voltage source (IQ) generating the measurement pulses during active insulation monitoring and outputting them at the coupling output (AK),
c) optionally a controllable, high-voltage-proof third disconnect switch (S3) at the coupling output (AK) of the sensor (S), the third disconnect switch (S3) optionally coupling the pulse voltage source (IQ) to the electrical network or isolating it from the electrical network.

6. Sensor (S) according to claim 5, **characterized by** a computing unit for computing at least one resistance value (Rf1, Rf2, Rf3, Rf4) and/or one capacitance value (Cy1, Cy2, Cy3, Cy4) in the context of insulation monitoring.

7. Sensor (S) according to claim 6, **characterized in**
a) **that** the computing unit calculates the following variables as a function of the voltage measurement value at at least one of the voltage measurement terminals (M1-M3) and the measurement pulses of the pulse voltage source (IQ):
a1) a first resistance (Rf1) between the high-side of the electrical network before the high-side contactor (RHV+) on the one hand and the chassis ground (GND_{CHASSIS}) on the other hand, and/or
a2) a first capacitance (Cy1) between the high-side of the electrical network upstream of the high-side contactor (RHV+) on the one hand and the chassis ground (GND_{CHASSIS}) on the other hand, and/or
b) **that** the computing unit calculates the following variables as a function of the voltage measurement value at at least one of the voltage measurement terminals (M1-M3) and the measurement pulses of the pulse voltage source (IQ):
b1) a second resistance (Rf2) between the low-side of the electrical network before the low-side contactor (RHV-) on the one hand and the chassis ground (GND_{CHASSIS}) on the other hand, and/or
b2) a second capacitance (Cy2) between the low-side of the electrical network upstream of the low-side contactor (RHV ) on the one hand and the chassis ground (GND_{CHASSIS}) on the other hand, and/or
c) **that** the computing unit calculates the following variables as a function of the voltage measurement value at at least one of the voltage measurement terminals (M1-M3) and the measurement pulses of the pulse voltage source (IQ):
c1) a third resistance (Rf3) between the high-side of the electrical network behind the high-side contactor (RHV+) on the one hand and the chassis ground (GND_{CHASSIS}) on the other hand, and/or
c2) a third capacitance (Cy3) between the high side of the electrical network behind the high side contactor (RHV+) on the one hand and the chassis ground (GND_{CHASSIS}) on the other hand, and/or
d) **that** the computing unit calculates, as a function of the voltage measurement value at at least one of the voltage measurement terminals (M1-M3) and the measurement pulses of the pulse voltage source (IQ), the following variables:
d1) a fourth resistance (Rf4) between the low-side of the electrical network behind the low-side contactor (RHV-) on the one hand and the chassis ground (GND_{CHASSIS}) on the other hand, and/or
d2) a fourth capacitance (Cy4) between the low-side of the electrical network behind the low-side contactor (RHV-) on the one hand and the chassis ground (GND_{CHASSIS}) on the other hand.

8. Sensor (S) according to any of the preceding claims, **characterized by**
a) a fourth voltage measuring terminal (M4) for voltage measurement at a fourth measuring point (4) on the high-side of the electrical network before the switchable high-side contactor (RHV+) on the high-side of the electrical network,
b) a fifth voltage measuring terminal (M5) for voltage measurement at a fifth measuring point (5) in a secondary path running parallel to the switchable high-side contactor (RHV+) at the high-side of the electrical network, and/or
c) a sixth voltage measuring terminal (M6) for voltage measurement at a sixth measuring point (6) on the low side of the electrical network upstream of the switchable low-side contactor (RHV-) on the low side of the electrical network.

9. Battery management system for an electrical network, in particular for an on-board network of an electrically driven vehicle, comprising
a) the sensor (S) according to one of claims 3 to 8,
b) a first measurement path from the first voltage measurement terminal (M1) of the sensor (S) to the first measurement point (1) on the high side of the electrical network downstream of the high-side contactor (RHV+),
c) a second measuring path from the second voltage measuring terminal (M2) of the sensor (S) to the second measuring point (2) on the low side of the electrical network downstream of the low-side contactor (RHV ),
d) a third measuring path from the third voltage measuring terminal (M3) of the sensor (S) to the third measuring point (3) at the high-side of the electrical network before the high-side contactor (RHV+), and
e) a coupling path between the coupling output (AK) of the sensor (S) and the chassis ground (GND_{CHASSIS}).

10. Electrical network, in particular on-board network of a vehicle with a battery management system according to claim 9, in particular with the following further components:
a) a battery (BAT) for feeding the electrical network, the battery (BAT) preferably being rechargeable, and/or
b) a discharge circuit (Rx) between the high-side and the low-side of the electrical network downstream of the high-side contactor (RHV+) and downstream of the low-side contactor (RHV-), and/or
c) an inverter (INV) fed by the high-side and the low-side of the electrical network.

11. Vehicle, in particular electric car, with an electrical network according to claim 10.

## Revendications

1. Capteur (S) pour un réseau électrique avec un côté haut pour la connexion à un pôle positif (+) d'une batterie (BAT), un côté bas pour la connexion à un pôle négatif (+) de la batterie (BAT) et une masse de châssis (GND_{chassis}), notamment pour un réseau de bord électrique d'un véhicule à propulsion électrique, notamment dans une voiture électrique, avec
a) un dispositif de mesure (ME) pour la mesure de courant et/ou pour la mesure de tension dans le réseau électrique, notamment avec une résistance de mesure de courant à faible impédance pour la mesure de courant selon la technique à quatre fils, et
b) un dispositif de surveillance d'isolation (ME, IQ, Rk, S3) intégré pour la surveillance d'une isolation électrique du côté haut et/ou côté bas du réseau électrique, dans lequel le dispositif de surveillance d'isolation (ME, IQ, Rk, S3)
b1) fonctionne activement et applique des impulsions de mesure CA dans le réseau électrique pour la surveillance d'isolation, et
b2) est couplé au réseau électrique de manière capacitive ou résistive,
**caractérisé en ce**
c) **que** le dispositif de surveillance d'isolation (ME, IQ, Rk, S3) actif détermine une capacité de fuite (Cy1, Cy2, Cy3, Cy4) entre le côté bas et/ou le côté haut du réseau électrique d'une part et la masse de châssis (GND_{chassis}) du réseau électrique d'autre part, et
d) **que** le dispositif de surveillance d'isolation (ME, IQ, Rk, S3) actif adapte la fréquence des impulsions de mesure en fonction de la capacité de fuite (Cy1, Cy2, Cy3, Cy4) déterminée.

2. Capteur (S) selon la revendication 1, **caractérisé par**
a) un premier raccordement électrique (A1) pour introduire un courant de secteur (I) du réseau électrique dans le capteur (S),
b) un deuxième raccordement électrique (A2) pour évacuer le courant de secteur (I) du réseau électrique du capteur (S),
c) dans lequel le dispositif de mesure (ME) mesure le courant de secteur (I).

3. Capteur (S) selon l'une quelconque des revendications précédentes, **caractérisé par**
a) un premier raccord de mesure de tension (M1) pour la mesure de tension sur un premier point de mesure (1) sur le côté haut du réseau électrique derrière un contacteur côté haut (RHV+) commutable sur le côté haut du réseau électrique, et
b) un deuxième raccord de mesure de tension (M2) pour la mesure de tension sur un deuxième point de mesure (2) sur le côté bas du réseau électrique derrière un contacteur côté bas (RHV-) commutable sur le côté bas du réseau électrique, et
c) un troisième raccord de mesure de tension (M3) pour la mesure de tension sur un troisième point de mesure (3) sur le côté haut du réseau électrique entre la batterie (BAT) et le contacteur côté haut (RHV+) sur le côté haut du réseau électrique.

4. Capteur (S) selon la revendication 3, **caractérisé par**
a) un premier sectionneur (S1) contrôlable, résistant à la haute tension sur le premier raccord de mesure de tension (M1), dans lequel le premier sectionneur (S1) permet sélectivement une interrogation de mesure sur le premier raccord de mesure de tension (M1) ou sépare le premier raccord de mesure de tension (M1), et/ou
b) un deuxième sectionneur (S2) contrôlable, résistant à la haute tension sur le deuxième raccord de mesure de tension (M2), dans lequel le deuxième sectionneur (S2) permet sélectivement une interrogation de mesure sur le deuxième raccord de mesure de tension (M2) ou sépare le deuxième raccord de mesure de tension (M2) .

5. Capteur (S) selon l'une quelconque des revendications précédentes, **caractérisé par**
a) une sortie de couplage (AK) pour coupler le capteur (S) à une masse de châssis (GND_{chassis}), notamment au véhicule, dans lequel la sortie de couplage (AK) est de préférence à haute impédance,
b) une source de tension d'impulsion (IQ) pour la surveillance d'isolation active, dans lequel la source de tension d'impulsion (IQ) génère les impulsions de mesure lors de la surveillance d'isolation active et les délivre à la sortie de couplage (AK),
c) éventuellement, un troisième sectionneur (S3) contrôlable, résistant à la haute tension sur la sortie de couplage (AK) du capteur (S), dans lequel le troisième sectionneur (S3) sélectivement couple la source de tension d'impulsion (IQ) au réseau électrique ou la découple du réseau électrique.

6. Capteur (S) selon la revendication 5, **caractérisé par** une unité de calcul pour le calcul d'au moins une valeur de résistance (Rf1, Rf2, Rf3, Rf4) et/ou d'une valeur de capacité (Cy1, Cy2, Cy3, Cy4) dans le cadre de la surveillance d'isolation.

7. Capteur (S) selon la revendication 6, **caractérisé en ce**
a) **que** l'unité de calcul calcule les grandeurs suivantes en fonction de la valeur de mesure de tension sur au moins l'un des raccords de mesure de tension (M1-M3) et des impulsions de mesure de la source de tension d'impulsion (IQ) :
a1) une première résistance (Rf1) entre le côté haut du réseau électrique devant le contacteur côté haut (RHV+) d'une part et la masse de châssis (GND_{chassis}) d'autre part, et/ou
a2) une première capacité (Cy1) entre le côté haut du réseau électrique devant le contacteur côté haut (RHV+) d'une part et la masse de châssis (GND_{chassis}) d'autre part, et/ou
b) **que** l'unité de calcul calcule les grandeurs suivantes en fonction de la valeur de mesure de tension sur au moins l'un des raccords de mesure de tension (M1-M3) et des impulsions de mesure de la source de tension d'impulsion (IQ) :
b1) une deuxième résistance (Rf2) entre le côté bas du réseau électrique devant le contacteur côté bas (RHV-) d'une part et la masse de châssis (GND_{chassis}) d'autre part, et/ou
b2) une deuxième capacité (Cy2) entre le côté bas du réseau électrique devant le contacteur côté bas (RHV-) d'une part et la masse de châssis (GND_{chassis}) d'autre part, et/ou
c) **que** l'unité de calcul calcule les grandeurs suivantes en fonction de la valeur de mesure de tension sur au moins l'un des raccords de mesure de tension (M1-M3) et des impulsions de mesure de la source de tension d'impulsion (IQ) :
c1) une troisième résistance (Rf3) entre le côté haut du réseau électrique derrière le contacteur côté haut (RHV+) d'une part et la masse de châssis (GND_{chassis}) d'autre part, et/ou
c2) une troisième capacité (Cy3) entre le côté haut du réseau électrique derrière le contacteur côté haut (RHV+) d'une part et la masse de châssis (GND_{chassis}) d'autre part, et/ou
d) **que** l'unité de calcul calcule les grandeurs suivantes en fonction de la valeur de mesure de tension sur au moins l'un des raccords de mesure de tension (M1-M3) et des impulsions de mesure de la source de tension d'impulsion (IQ) :
d1) une quatrième résistance (Rf4) entre le côté bas du réseau électrique derrière le contacteur côté bas (RHV-) d'une part et la masse de châssis (GND_{chassis}) d'autre part, et/ou
d2) une quatrième capacité (Cy4) entre le côté bas du réseau électrique derrière le contacteur côté bas (RHV-) d'une part et la masse de châssis (GND_{chassis}) d'autre part.

8. Capteur (S) selon l'une quelconque des revendications précédentes, **caractérisé par**
a) un quatrième raccord de mesure de tension (M4) pour la mesure de tension sur un quatrième point de mesure (4) sur le côté haut du réseau électrique devant le contacteur côté haut (RHV+) commutable sur le côté haut du réseau électrique,
b) un cinquième raccord de mesure de tension (M5) pour la mesure de tension sur un cinquième point de mesure (5) dans une voie secondaire qui passe parallèlement au contacteur côté haut (RHV+) commutable sur le côté haut du réseau électrique, et/ou
c) un sixième raccord de mesure de tension (M6) pour la mesure de tension sur un sixième point de mesure (6) sur le côté bas du réseau électrique devant le contacteur côté bas (RHV-) commutable sur le côté bas du réseau électrique.

9. Système de gestion de batterie pour un réseau électrique, notamment pour un réseau de bord d'un véhicule à propulsion électrique, avec
a) le capteur (S) selon l'une quelconque des revendications 3 à 8,
b) une première voie de mesure du premier raccord de mesure de tension (M1) du capteur (S) au premier point de mesure (1) sur le côté haut du réseau électrique derrière le contacteur côté haut (RHV+),
c) une deuxième voie de mesure du deuxième raccord de mesure de tension (M2) du capteur (S) au deuxième point de mesure (2) sur le côté bas du réseau électrique derrière le contacteur côté bas (RHV-),
d) une troisième voie de mesure du troisième raccord de mesure de tension (M3) du capteur (S) au troisième point de mesure (3) sur le côté haut du réseau électrique devant le contacteur côté haut (RHV+), et
e) une voie de couplage entre la sortie de couplage (AK) du capteur (S) et la masse de châssis (GND_{chassis}).

10. Réseau électrique, notamment réseau de bord d'un véhicule avec un système de gestion de batterie selon la revendication 9, notamment avec les composants supplémentaires suivants :
a) une batterie (BAT) pour l'alimentation du réseau électrique, dans lequel la batterie (BAT) est de préférence rechargeable, et/ou
b) un circuit de décharge (Rx) entre le côté haut et le côté bas du réseau électrique derrière le contacteur côté haut (RHV+) et derrière le contacteur côté bas (RHV-), et/ou
c) un onduleur (INV), qui est alimenté par le côté haut et le côté bas du réseau électrique.

11. Véhicule, notamment voiture électrique, avec un réseau de bord selon la revendication 10.
